# EUROPEAN PATENT APPLICATION

(11) **EP 1 601 104 A1**
(43) Date of publication of application: **30.11.2005**
(21) Application number: 05011269.7
(22) Date of filing: 24.05.2005
(51) Int. Cl.: H03K 17/082, H03K 17/16

(54) **Overcurrent detecting apparatus**

(30) Priority: 25.05.2004 JP 2004154341
(71) Applicant: YAZAKI CORPORATION, Minato-ku, Tokyo (JP)
(72) Inventor: Watanabe, Shuichi, Fukuju-cho Toyota-shi Aichi (JP)
(74) Representative: Grünecker, Kinkeldey, Stockmair & Schwanhäusser Anwaltssozietät

(57) **Abstract**

An overcurrent detecting apparatus includes a filter circuit (R4,C1) that filters a signal corresponding to an electric current flowing in a load (3), and a comparison circuit (CMP1) that compare an input signal with a predetermined reference value for detecting an overcurrent of the electric current flowing in the load (3). The input signal is the signal filtered by the filter circuit (R4,C1).

## Description

### BACKGROUND OF THE INVENTION

The present invention relates to an overcurrent detecting apparatus adapted to detect an overcurrent flowing in a predetermined load, and more particularly to an overcurrent detecting apparatus using a multi-source FET circuit.

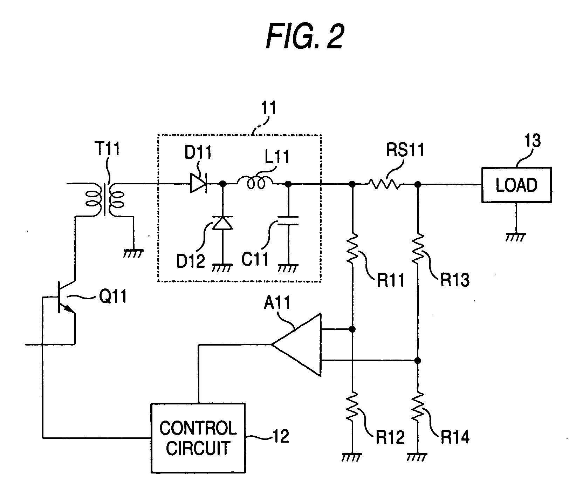

Various kinds of overcurrent detecting apparatuses have heretofore been proposed for protecting relative circuits fuselessly. Fig. 2 is a circuit diagram showing a related overcurrent detecting apparatus of this kind.

Referring to Fig. 2, a voltage excited by a secondary winding of a transformer T11 is converted into a DC current by a rectification smoothing circuit 11 made of diodes D11, D12, a choke coil L11 and a capacitor C11, and the DC current is supplied to a load 13. A voltage corresponding to the current flowing in the load 13 and occurring in a current detecting resistor RS11 interposed between the rectification smoothing circuit 11 and load 13 is supplied to an operation amplifier A11 through partial pressure resistors R11, R12 and partial pressure resistors R13, R14.

The operation amplifier A11 feeds back a signal corresponding to the voltage occurring in the current detecting resistor RS11, and a control circuit 12 controls an ON-OFF ratio of a switching transistor Q11 on the basis of this signal, an overcurrent being thereby prevented from flowing to the load 13.

JP-A-10-75526 discloses the above related techniques.

Although the related overcurrent detecting apparatus described above attains the fuseless protection of the relative circuit, various problems arise therein since the current detecting resistor R11 is used for the detection of an overcurrent. In this structure, a peak current flowing in the load 13 is necessarily detected. Therefore, when a pulsating current generating load, for example, an electric horn and the like is connected as a load 13, a proper current cannot be distinguished from an overcurrent, so that erroneous detection occurs. Also, when noise exceeding an overcurrent threshold level is inputted, erroneous detection occurs. Moreover, since the current detecting resistor RS11 is series-connected to the load 13, this resistor causes heat to occur.

### SUMMARY OF THE INVENTION

Therefore, in view of the above-mentioned present situation, an object of the present invention is to provide an overcurrent detecting apparatus capable of preventing erroneous detection of an overcurrent when a pulsating current generating load is connected, and when noise, etc. occur.

In order to achieve the above object, according to the present invention, there is provided an overcurrent detecting apparatus, comprising:
a filter circuit that filters a signal corresponding to an electric current flowing in a load; and
a comparison circuit that compare an input signal with a predetermined reference value for detecting an overcurrent of the electric current flowing in the load,
wherein the input signal is the signal filtered by the filter circuit.

In the above configuration, a signal corresponding to a current flowing in the load is filtered, and the resultant signal is used as an input signal to be supplied to the comparison circuit for detecting an overcurrent. This enables not a peak current but an input signal near the filtered DC current to be supplied to the comparison circuit. This enables the occurrence of erroneous detection to be prevented when a pulsating current generating load is connected and when noise occurs.

Preferably, the overcurrent detecting apparatus further including:
a multi-source FET circuit that includes a first FET series-connected to the load, and a second FET parallel-connected to the first FET, the second FET adapted to output a signal corresponding to the current flowing in the load from a sense source terminal thereof; and
an overcurrent detecting threshold value resistor that is disposed between the sense source terminal and the earth. A voltage applied to the overcurrent detecting threshold value resistor is detected through the filter circuit so that the detected voltage is supplied as the input signal to the comparison circuit.

In the above configuration, the overcurrent detecting apparatus includes the multi-source FET circuit, and the overcurrent detecting threshold value resistor interposed between the sense terminal of the multi-source FET circuit and the earth, the voltage applied to the overcurrent detecting threshold value resistor being detected through the filter circuit, the resultant signal being supplied as an input signal to the comparison circuit. This enables the occurrence of erroneous detection to be prevented, and the calorific power to be reduced.

Preferably, the filter circuit is configured by a RC integrating circuit.

In the above configuration, the filter constant determined in conformity with the connected load can be suitably set since the filter circuit is configurered by the RC integrating circuit. This enables a range of application of the apparatus to be widened.

### BRIEF DESCRIPTION OF THE DRAWINGS

The above objects and advantages of the present invention will become more apparent by describing in detail preferred exemplary embodiments thereof with reference to the accompanying drawings, wherein:
Fig. 1 is a circuit diagram showing the overcurrent detecting apparatus in an embodiment of the present invention; and
Fig. 2 is a circuit diagram showing a related overcurrent detecting apparatus.

### DETAILED DESCRIPTION OF THE PREFERRED EMBODIMENTS

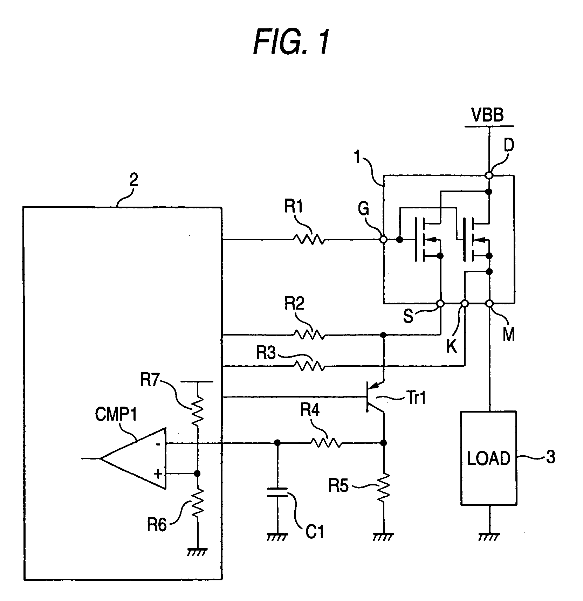

An embodiment of the present invention will now be described on the basis of the drawing. Fig. 1 is a circuit diagram showing an overcurrent detecting circuit in one embodiment of the present invention.

As shown in Fig. 1, this overcurrent detecting apparatus includes a multi-source FET circuit 1 connected to a load 3, a control circuit 2, and a filter circuit configured by a resistor R4 and a capacitor C1.

The multi-source FET circuit 1 is interposed between a power source VBB and load 3. The multi-source FET circuit 1 includes a first FET series-connected to a main source terminal M of the load 3, and a second FET parallel-connected to the first FET and adapted to output from a sense source terminal S a signal corresponding to a current flowing in the load 3. According to such a circuit structure, a current flowing in the load 3 connected to the main source terminal M can be divided and taken out from the sense terminal S. A reference marks D denotes a drain terminal, G denotes a gate terminal, and K denotes a Kelvin source terminal.

Resistors R2 and R3 are connected to the sense source terminal S and Kelvin source terminal K respectively of the multi-source FET circuit 1. A transistor Tr1 is parallel-connected between the sense source terminal S and the R2, and an overcurrent detecting threshold value resistor R5 is interposed between a collector side of the transistor Tr1 and the earth. Among the collector side of the transistor Tr1, a node of the resistor R5 and an input terminal of a comparison circuit CMP 1, a filter circuit made of a filter-use resistor R4 and a filter-use capacitor C1. A gate resistor R1 is connected to the gate terminal G.

Since the overcurrent detecting threshold value resistor R5 is interposed between the sense terminal S of the multi-source FET circuit and the earth so as to supply a voltage, which is applied to the overcurrent detecting threshold value resistor R5, to the comparison circuit CMP1, the calorific power can be reduced greatly.

The control circuit 2 includes the overcurrent detecting comparison circuit CMP1 to the reference terminal of which the reference resistors R6 and R7 are connected. The control circuit 2 is, for example, circuit-integrated, and may be formed by providing the same with a charge pump circuit (not shown) and a driver circuit (not shown).

In such a structure, the current outputted from the sense source terminal and corresponding to the current flowing in the load 3 is outputted to the emitter side of the transistor Tr1. When the transistor Tr1 is turned on, the voltage applied to the overcurrent detecting threshold value resistor R5, which is connected to the collector side of the transistor Tr1, is detected through the filter circuit, which is made of the resistor R4 and capacitor C1, and supplied to the input terminal of the comparison circuit. In the comparison circuit CMP1, this voltage is compared with the reference voltage divided in the reference resistors R6 and R7 and applied to the reference terminal, and a control signal corresponding to the results of the comparison is outputted from the comparison circuit CMP1.

This control signal can be utilized to control the ON-OFF ratio of the switching transistor connected as shown, for example, in Fig. 2. This enables a fuseless relative circuit to be protected against an overcurrent.

A signal corresponding to the current flowing in the load 3 is thus filtered, and the resultant signal is used as an input signal for the overcurrent detecting comparison circuit CMP1. Therefore, not a peak current but a filtered near DC current input signal is necessarily supplied to the comparison circuit CMP1. Therefore, the occurrence of erroneous detection can be prevented when a pulsating current generating load is connected and when noise occurs.

Since the filter circuit is formed by an integrated circuit of RC, a filter constant determined in conformity with the connected load can be suitably set. As mentioned above, it is possible not only to carry out the signal filtering operation so that a near-DC current signal is obtained but also to improve the detecting sensitivity by changing the RC time constant so that a current near a peak current can be detected. Therefore, using a filter circuit made of an integrating circuit of RC in this apparatus enables the range of application of the apparatus to be widened. This also serves as an aid for the promotion of the standardization of the apparatus.

Since the output signal from the comparison circuit CMP1 is inputted into the interior of the circuit-integrated control circuit 2, the circuit CMP1 is suitable for increasing the functions of the apparatus. For example, when logic elements are combined together in the control circuit, it becomes possible to add an erroneous detection preventing function of delaying a necessary period of time after the overcurrent is detected, and outputting a control signal representative of an overcurrent after the output signal is compared with a predetermined gate input.

According to the embodiment of the present invention described above, an overcurrent detecting apparatus capable of preventing the occurrence of erroneous detection both when a pulsating current generating load is connected and when noise occurs. Since a transistor circuit is used, the apparatus has a fuseless and maintenance-free structure, and it is a matter of course that the apparatus has a high space efficiency.

Although the invention has been illustrated and described for the particular preferred embodiments, it is apparent to a person skilled in the art that various changes and modifications can be made on the basis of the teachings of the invention. It is apparent that such changes and modifications are within the spirit, scope, and intention of the invention as defined by the appended claims.

The present application is based on Japan Patent Application No. 2004-154341 filed on May 25, 2004, the contents of which are incorporated herein for reference.

## Claims

1. An overcurrent detecting apparatus, comprising:
a filter circuit that filters a signal corresponding to an electric current flowing in a load; and
a comparison circuit that compare an input signal with a predetermined reference value for detecting an overcurrent of the electric current flowing in the load,
wherein the input signal is the signal filtered by the filter circuit.

2. The overcurrent detecting apparatus as set forth in claim 1, further comprising:
a multi-source FET circuit that includes a first FET series-connected to the load, and a second FET parallel-connected to the first FET, the second FET adapted to output a signal corresponding to the current flowing in the load from a sense source terminal thereof; and
an overcurrent detecting threshold value resistor that is disposed between the sense source terminal and the earth,
wherein a voltage applied to the overcurrent detecting threshold value resistor is detected through the filter circuit so that the detected voltage is supplied as the input signal to the comparison circuit.

3. The overcurrent detecting apparatus as set forth in claim 1, wherein the filter circuit is configured by a RC integrating circuit.
